# EUROPEAN PATENT APPLICATION

(11) **EP 3 241 868 A1**
(43) Date of publication of application: **08.11.2017**
(21) Application number: 16867380.4
(22) Date of filing: 08.09.2016
(51) Int. Cl.: C08L 63/00, C08G 59/32, C08K 5/357, C08G 59/62, C08K 3/36, B32B 15/092, B32B 27/18, B32B 33/00

(54) **HALOGEN-FREE THERMOSETTING RESIN COMPOSITION, AND PREPREG AND LAMINATE FOR PRINTED CIRCUITS USING SAME**

(30) Priority: 04.03.2016 CN 201610124988
(71) Applicant: Shengyi Technology Co. Ltd., Dongguan City, Guangdong 523808 (CN)
(72) Inventor: YOU, Jiang, Dongguan Guangdong 523808 (CN); HUANG, Tianhui, Dongguan Guangdong 523808 (CN); XU, Yongjing, Dongguan Guangdong 523808 (CN); YANG, Zhongqiang, Dongguan Guangdong 523808 (CN)
(74) Representative: Wallinger Ricker Schlotter Tostmann
(86) International application number: PCT/CN2016/098449
(87) International publication number: WO 2017/148127

(57) **Abstract**

The present invention relates to a halogen-free thermosetting resin composition, a prepreg and a laminate for printed circuit boards using the same. The halogen-free thermosetting resin composition comprises, based on 100 parts by weight of organic solids, (A) from 16 to 42 parts by weight of a halogen-free epoxy resin, (B) from 1.5 to 4.8 parts by weight of a compound containing dihydrobenzoxazine ring; (C) from 10 to 28 parts by weight of a phosphorus-containing bisphenol curing agent, wherein the phosphorus-containing bisphenol curing agent has a weight average molecular weight of 1000-6500, and (D) from 30 to 70 parts by weight of silicon dioxide. The prepreg and laminate for printed circuit boards prepared from the halogen-free thermosetting resin composition have high glass transition temperature, excellent dielectric performances, low water absorption, high heat resistance and better processability, and can achieve halogen-free flame retardancy and UL94 V-0.

## Description

### Technical field

The present invention relates to a halogen-free thermosetting resin composition, particularly to a prepreg and a laminate for printed circuit boards prepared from the same.

### Background art

Conventional laminates for printed circuit boards achieve flame retardancy by using brominated flame retardants, especially tetrabromobisphenol A-type epoxy resin which has better flame retardancy, but will produce hydrogen bromide gas during combustion. In recent years, carcinogens such as dioxin, dibenzofuran and the like have been detected in combustion products of electrical and electronic equipment waste containing halogens such as bromine, chlorine and the like. Thus, the use of brominated epoxy resins is limited. Waste Electrical and Electronic Equipment Directive and the Restriction of the Use of Certain Hazardous Substances in Electrical and Electronic Equipments were formally implemented by European Union on July 1st, 2006. The development of halogen-free flame retardant copper-clad laminates has become a hot spot in the industry, and copper-clad laminate manufacturers have launched their own halogen-free flame retardant copper-clad laminate.

With the high speed and multi-functionalization of information processing of consumer electronic products, the application frequency continuously increases. Besides that the requirements on environmental protection are getting higher, it is required that the dielectric constant and the dielectric loss value become lower. Thus it becomes a hot pursuit in the substrate industry to reduce Dk/Df.

The compounds in CN1723243A and JP NO. 2001/302,879 disclose reactive phosphonates which are both used as flame retardants. Only hydroxyl groups of phosphonates can react with epoxy resin. Such hydroxyl groups of phosphonates have a high equivalent and a low curing efficiency. Additional curing agents, such as benzoxazine, phenolic aldehyde and the like, are required. The addition of these curing agents will deteriorate the dielectric performances of cured products, and cannot meet the requirements of laminates in the thermosetting high-speed industry on dielectric performances. Moreover, higher benzoxazine content cannot achieve lower dielectric performances.

CN1723243A discloses in the description that phosphonates require a phosphorus content higher than about 12%. Such phosphonates have a too high phosphorus content and a dense distribution. The cured products are easy to absorb water so as to delaminate when used in printed circuit boards. Moreover, CN1723243A does not define the molecular weight of phosphonates.

### Disclosure of the invention

The object of the present invention lies in providing a novel halogen-free thermosetting resin composition, a prepreg and a laminate for printed circuit boards using the same. The laminate for printed circuit boards prepared from the resin composition has high glass transition temperature, excellent dielectric performances, low water absorption, high heat resistance and better processability, and can achieve halogen-free flame retardancy and UL94 V-0.

In order to achieve the aforesaid object, the inventor carried out in-depth studies repeatedly and found that the novel composition prepared by suitably mixing a halogen-free epoxy resin, a compound containing dihydrobenzoxazine ring, phosphorus-containing bisphenol, silicon dioxide and optionally other substances can achieve the aforesaid object.

That is to say, the present invention discloses the following technical solution,
a halogen-free thermosetting resin composition comprising the following four substances as essential components, based on 100 parts by weight of organic solids,
   (A) from 16 to 42 parts by weight of a halogen-free epoxy resin,
   (B) from 1.5 to 4.8 parts by weight of a compound containing dihydrobenzoxazine ring;
   (C) from 10 to 28 parts by weight of a phosphorus-containing bisphenol curing agent, wherein the phosphorus-containing bisphenol curing agent has a weight average molecular weight of 1000-6500, and
   (D) from 30 to 70 parts by weight of silicon dioxide.

The inventor found that phosphorus-containing bisphenol having a specific structure can be used as the curing agent of epoxy resins. The reactive groups thereof comprise hydroxyl groups at both ends and phosphorus units, and the reaction produces no secondary hydroxyl groups. The cured products have high glass transition temperature, and excellent dielectric properties and heat resistance. In addition, the phosphorus-containing bisphenol has a high phosphorus content, and has efficacy of halogen-free flame retardancy while as the curing agent, without addition of additional flame retardants.

The present invention discloses using a phosphorus-containing bisphenol having a phosphorus content of 8wt.%-10wt.%, a high molecular structure symmetry and a homogeneous and non-dense phosphorus distribution, which can be used as the curing agent for epoxy resins. Besides that hydroxyl groups at both ends can react with epoxy groups of epoxy resins, phosphorus units can also react with secondary hydroxyl groups at a temperature higher than 175°C to eliminate secondary hydroxyl groups, so that the cured products have a high crosslinking density and a low secondary hydroxyl group content, so as to have a high Tg and excellent dielectric properties.

The present invention discloses using a phosphorus-containing bisphenol having a specific molecular weight, which has a lower melt viscosity within the specific molecular weight range. Thus more silicon dioxide can be added into the composition while maintaining appropriate melt viscosity and better processability, so as to increase the modulus and size stability of the cued products, and further decrease the water absorption of the cured products.

The reaction process of the phosphorus-containing bisphenol of the present invention and epoxy resin is as follows.

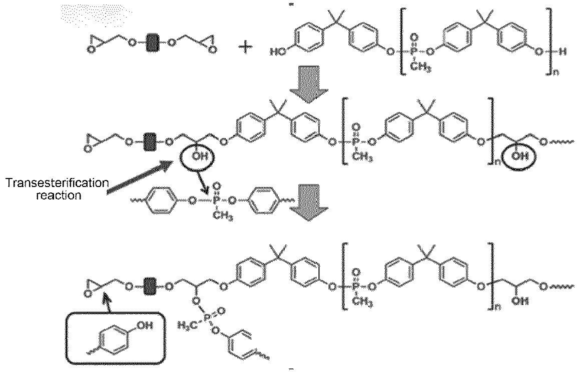

The halogen-free thermosetting resin composition of the present invention uses a halogen-free epoxy resin having specific molecular structure, and has a higher functionality and better dielectric properties. The cured products thereof have a higher Tg and a low water absorption.

The halogen-free thermosetting resin composition of the present invention uses a compound having dihydrobenzene ring which has a higher Tg, better dielectric properties and heat resistance and a low water absorption. Into the aforesaid halogen-free epoxy resin is added the compound having dihydrobenzene ring. The cured products have not only a high Tg, a high heat resistance and a low water absorption, but also excellent dielectric properties and a higher modulus which can improve the expansion and contraction problem of laminates during the processing. In addition, the compound having dihydrobenzene ring contains nitrogen element. The nitrogen element and phosphorus element in the phosphorus-containing bisphenol have synergistic effect on flame retardancy, and can decrease phosphorus content required for the cured products to achieve the flame retardancy of UL 94V-0, and further reduce the water absorption.

The inventor found that, when the addition amount of the compound having dihydrobenzene ring is between 1.5 and 4.8 parts by weight, as compared to higher than 5 or lower than 1.5 parts by weight, they have better synergistic effects on curing and flame retardancy together with phosphorus-containing bisphenol, and can further reduce the water absorption.

The halogen-free thermosetting resin composition of the present invention further comprises 30%-70% of silicon dioxide, which not only can solve the problems of low melt viscosity and high resin recession of phosphorus-containing bisphenol, but also can decrease the coefficient of thermal expansion of the cured products, increase the modulus and size stability, and further improve flame retardancy and reduce the dielectric loss.

The present invention further provides a prepreg prepared by impregnating a base material with the aforesaid halogen-free thermosetting resin composition and then heating and drying, wherein the base material is non-woven fabrics or other fabrics. The present invention further provides a laminate prepared by heating and pressing one or more sheets of prepregs and bonding the prepregs, as well as a laminate for printed circuit boards comprising metal foils bonded to one or two sides of the laminate.

As compared to the prior art, the present invention at least has the following beneficial effects.
(1) The halogen-free thermosetting resin composition of the present invention uses a halogen-free epoxy resin having specific molecular structure, and has a higher functionality and better dielectric properties. The cured products thereof have a higher Tg and a low water absorption.
(2) The halogen-free thermosetting resin composition of the present invention uses a compound having dihydrobenzene ring which has a higher Tg and a low water absorption, so as to greatly improve the water absorption of the cured products. In addition, the compound having dihydrobenzene ring contains nitrogen element. The nitrogen element and phosphorus element in the phosphorus-containing bisphenol have synergistic effect on flame retardancy, and can decrease phosphorus content required for the cured products to achieve the UL 94V-0, and further reduce the water absorption. Especially as compared to higher than 5 or lower than 1.5 parts by weight, when the addition amount thereof is controlled between 1.5 and 4.8 parts by weight, they have better synergistic effects on curing and flame retardancy together with phosphorus-containing bisphenol, and can further reduce the water absorption.
(3) The halogen-free thermosetting resin composition of the present invention uses phosphorus-containing bisphenol as the curing agent and flame retardant. The phosphorus-containing bisphenol has a high structural symmetry, and hydroxyl groups at both ends can react with the epoxy groups of epoxy resins. Moreover, the phosphate structure can react with secondary hydroxyl groups in epoxy resins, and the cured products have a higher Tg and excellent dielectric properties. Meanwhile, the phosphorus-containing bisphenol has a high phosphorus content, and can achieve flame retardancy without sacrificing Tg, dielectric properties, heat resistance, moisture resistance of the cured products. The cured products also can achieve a flame retardancy of UL94 V-0 level. In addition, the phosphorus-containing bisphenol has a low molecular weight, a low melt viscosity, and excellent wettability to filler. When the filler ratio is higher, there is still a lower melt viscosity and a better processability.
(4) The halogen-free thermosetting resin composition of the present invention further comprises 30%-70% of silicon dioxide, which not only can solve the problems of low melt viscosity and high resin recession of phosphorus-containing bisphenol, but also can decrease the coefficient of thermal expansion, increase the modulus and size stability, and further improve flame retardancy and reduce the dielectric loss.
(5) The prepreg and the laminate for printed circuit boards prepared from such resin composition have a high glass transition temperature which may be as high as 185°C, excellent dielectric performances , wherein the dielectric constant thereof ranges from 3.53 to 3.60, a low water absorption within 0.07-0.08%, dip soldering resistance performance which is higher than 120s and better processability, and can achieve halogen-free flame retardancy and reach the UL94 V-0 level.

### Embodiments

The present invention discloses the following technical solution:
a halogen-free thermosetting resin composition comprising the following four substances as essential components, based on 100 parts by weight of organic solids,
   (A) from 16 to 42 parts by weight of a halogen-free epoxy resin,
   (B) from 1.5 to 4.8 parts by weight of a compound containing dihydrobenzoxazine ring;
   (C) from 10 to 28 parts by weight of a phosphorus-containing bisphenol curing agent, wherein the phosphorus-containing bisphenol curing agent has a weight average molecular weight of 1000-6500; and
   (D) from 30 to 70 parts by weight of silicon dioxide.

Each component is detailedly stated as follows.

The component (A) of the present invention, i.e. the halogen-free epoxy resin, is in an amount of 16-42 parts by weight, e.g. 16, 18, 19, 20, 22, 23, 24, 25, 26, 27, 28, 29, 30, 32, 34, 36, 38, 40 or 42 parts by weight.

According to the present invention, the halogen-free epoxy resin is anyone selected from the group consisting of bisphenol A epoxy resin, bisphenol F epoxy resin, o-cresol novolac epoxy resin, bisphenol A novolac epoxy resin, triphenol novolac epoxy resin, dicyclopentadiene novolac epoxy resin, biphenyl novolac epoxy resin, alkylbenzene novolac epoxy resin and naphthol novolac epoxy resin, or a mixture of at least two selected therefrom. The aforesaid epoxy resins all are halogen-free epoxy resins.

According to the present invention, the halogen-free epoxy resin is preferably selected from the epoxy resins having the following structure: 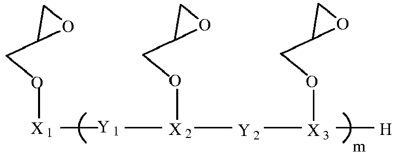 wherein X₁, X₂ and X₃ are each independently selected from the group consisting of 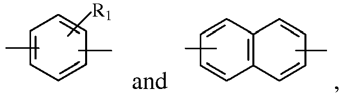 wherein R₁ is anyone selected from the group consisting of hydrogen atom, substituted or unsubstituted C1-C5 (e.g. C2, C3 or C4) linear chain alkyl group, and substituted or unsubstituted C1-C5 (e.g. C2, C3 or C4) branched chain alkyl group;
Y₁ and Y₂ are each independently anyone selected from the group consisting of single bond, -CH₂-, 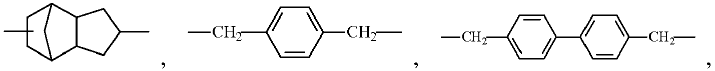 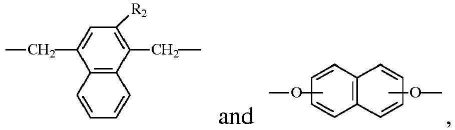 wherein R₂ is anyone selected from the group consisting of hydrogen atom, substituted or unsubstituted C1-C5 (e.g. C2, C3 or C4) linear chain alkyl group, and substituted or unsubstituted C1-C5 (e.g. C2, C3 or C4) branched chain alkyl group; and
m is an integer selected from 1-10, e.g. 2, 3, 4, 5, 6, 7, 8 or 9.

The halogen-free thermosetting resin composition of the present invention contains the halogen-free epoxy resin having the aforesaid specific molecular structure, and has a higher functionality and better dielectric performances. The cured products have a higher Tg and a lower water absorption.

The component (B) of the present invention, i.e. the compound containing dihydrobenzoxazine ring is in an amount of 1.5-4.8 parts by weight, e.g. 1.5, 1.8, 2.1, 2.4, 2.7, 3.0, 3.3, 3.6, 3.9, 4.2, 4.5 or 4.8 parts by weight. If the addition amount thereof is less than 1.5 parts by weight, the effects on decreasing the water absorption of the cured products and the synergistic effect on flame retardancy with phosphorus are not obvious; if the addition amount thereof is greater than 4.8 parts by weight, the cured products thereof have worse dielectric performances and a greater fragility, thereby resulting in a worse processability.

According to the present invention, the compound having dihydrobenzoxazine ring is anyone selected from the group consisting of bisphenol A benzoxazine shown in formula (I), bisphenol A benzoxazine shown in formula (II), bisphenol F benzoxazine, MDA (4,4-diaminodiphenylmethane) benzoxazine, phenolphthalein benzoxazine and dicyclopentadiene benzoxazine, or a mixture of at least two selected therefrom; 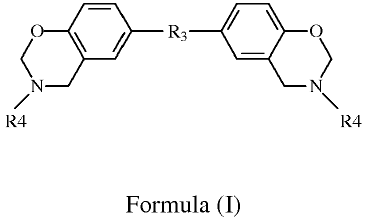 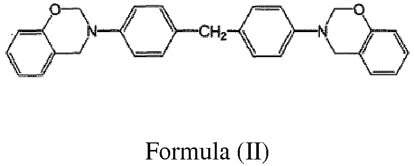 wherein R₃ is anyone selected from the group consisting of 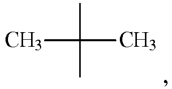 -CH₂-, 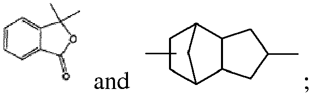 R₄ is

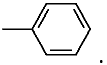

The component (C) of the present invention, i.e. the phosphorus-containing bisphenol as the curing agent and flame retardancy at the same time, is added in an amount of 10-28 parts by weight, e.g. 10, 12, 14, 16, 18, 20, 22, 24, 26 and 28 parts by weight. If the addition amount thereof is too less, the cured products have worse dielectric performances and flame retardancy; if the addition amount is too much, the cured products have a too high water absorption.

According to the present invention, phosphorus in the phosphorus-containing bisphenol curing agent is in an amount of 8-10wt.% of the phosphorus-containing bisphenol curing agent, e.g. 8wt.%, 8.2wt.%, 8.3wt.%, 8.5wt.%, 8.8wt.%, 9wt.%, 9.2wt.%, 9.5wt.%, 9.8wt.% and 10wt.%.

The present invention discloses using a phosphorus-containing bisphenol curing agent containing phosphorus in an amount of 8-10 wt.%, a high molecular structure symmetry and a homogeneous and non-dense phosphorus distribution, which can be used as the curing agent for epoxy resins. Besides that hydroxyl groups at both ends can react with epoxy groups of epoxy resins, phosphorus units may react with secondary hydroxyl groups at a temperature higher than 175°C to eliminate secondary hydroxyl groups, so as to make the cured products have a high crosslinking density and a low hydroxyl group content, and to have a high Tg and excellent dielectric performances.

According to the present invention, the phosphorus-containing bisphenol curing agent has the following structure: 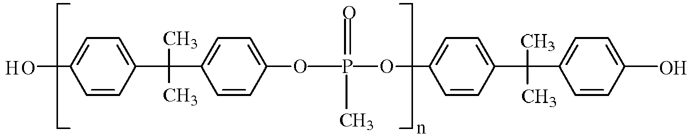 wherein n is an integer from 2 to 20, e.g. 3, 4, 5, 6, 7, 8, 10, 12, 13, 15, 17, 18 and 20, preferably an integer from 3 to 10.

According to the present invention, the phosphorus-containing bisphenol curing agent has a weight average molecular weight of 1000-6500, e.g. 1000, 1200, 1500, 1800, 2000, 2200, 2500, 2800, 3000, 3500, 4000, 4500, 4800, 5100, 5800, 6000 and 6500, preferably 1000-4500, further preferably 1000-3000. When the weight average molecular weight is less than 1000, the cured products have a low Tg and a worse heat resistance; when the weight average molecular weight is greater than 6500, the phosphorus-containing bisphenol has a worse solubility in organic solvents, so that a better and homogeneous glue solution cannot be obtained, and the process requirements of copper clad plates cannot be met.

The component (D) of the present invention, i.e. silicon dioxide, is added in an amount of 30-70 parts by weight, e.g. 30, 35, 40, 45, 50, 55, 60, 65 or 70 parts by weight. If the addition amount is too less, the resin composition has a lower melt viscosity during the processing; the resin recession is not easy to control; and the benefits for the modulus and size stability of the cured products are not obvious. If the addition amount is too much, the melt viscosity thereof is too high and the processability thereof is poor, so as to be disadvantageous to the production.

According to the present invention, the silicon dioxide is preferably molten silicon dioxide.

According to the present invention, there is no specific definition of the shape and particle size of the silicon dioxide. Preferably, the silicon dioxide has a median particle diameter of 0.01-50µm, e.g. 1µm, 6µm, 11µm, 16µm, 21µm, 26µm, 31µm, 36µm, 41µm or 46µm, preferably 0.01-20µm, further preferably 0.1-10µm. The fillers having such particle size range are easy to disperse in the glue solution.

If necessary, the halogen-free thermosetting resin composition further comprises a component (E) curing accelerator. The present invention does not specifically define the curing accelerator, as long as it can catalyze the reaction of epoxy functional groups and decrease the reaction temperature of the curing system. Preferably, the curing accelerator is anyone selected from the group consisting of imidazole compounds, derivatives of imidazole compounds, piperidine compounds, Lewis acid and triphenylphosphine, or a mixture of at least two selected therefrom. The imidazole compound is anyone selected from the group consisting of 2-methylimidazole, 2-ethyl-4-methylimidazole, 2-phenylimidazole and 2-undecylimidazole, or a mixture of at least two selected therefrom; the piperidine compound is anyone selected from the group consisting of 2,3-diaminopiperidine, 2,5-diaminopiperidine, 2,6-diaminopiperidine, 2-amino-3-methylpiperidine, 2-amino-4-methylpiperidine, 2-amino-3-nitropiperidine, 2-amino-5-nitropiperidine and 2-amino-4,4-dimethylpiperidine, or a mixture of at least two selected therefrom.

Preferably, the component (E) curing accelerator is added in an amount of from 0.01 to 1 part by weight, e.g. 0.05, 0.1, 0.15, 0.2, 0.25, 0.3, 0.35, 0.4, 0.45, 0.5, 0.55, 0.6, 0.65, 0.7, 0.75, 0.8, 0.85, 0.9 or 0.95 part by weight, preferably from 0.05 to 0.8 parts by weight, further preferably from 0.05 to 0.6 parts by weight, based on 100 parts by weight of the sum of the addition amounts of the components (A), (B), (C) and (D).

The wording "comprising/comprise(s)" in the present invention means further comprising other components than said components, wherein these other components endow the halogen-free thermosetting resin composition with different characteristics. In addition, the wording "comprising/comprise(s)" of the present invention may be replaced with "being" or "consisting/consist(s) of" in a closed manner.

For example, the halogen-free thermosetting resin composition further comprises various additives, specifically such as phosphorus-containing flame retardants, antioxidants, thermal stabilizers, antistatic agents, UV absorbers, pigments, colorants or lubricants and the like. These additives can be used alone, or in combination.

The conventional method for preparing the halogen-free thermosetting resin composition of the present invention comprises placing solids, then adding liquid solvent, stirring until solids are completely dissolved, then adding liquid resin and accelerator, continuing to homogeneously stir.

The solvent of the present invention is not specifically limited. The specific examples are listed as follows, e.g. alcohols, such as methanol, ethanol, butanol and the like; ethers, such as ethyl cellosolve, butyl cellosolve, ethylene glycol monomethyl ether, carbitol, butyl carbitol and the like; ketones, such as acetone, butanone, methyl ethyl ketone, cyclohexanone and the like; aromatic hydrocarbons, such as toluene, xylol and the like; esters, such as ethyl acetate, ethoxyethyl acetate and the like; nitrogen-containing solvents, such as N,N-dimethylformamide, N,N-dimethylacetamide and the like. The aforesaid solvents can be used alone, or in combination. Ketones, such as acetone, butanone, methyl ethyl ketone, cyclohexanone and the like, are preferred. Those skilled in the art can choose the addition amount of the solvents according to their experiences, so as to make the resin glue solution achieve suitable viscosity.

The prepreg of the present invention comprises a reinforcing material and the aforesaid halogen-free thermosetting resin composition attached thereon after impregnation and drying. The reinforcing material therein is not specifically defined, and it may be organic fiber, inorganic fiber woven fabrics or non-woven fabrics. The organic fibers may be aramid non-woven fabrics; the inorganic fiber woven fabrics may be E-glass fabric, D-glass fabric, S-glass fabric, T-glass fabric, NE-glass fabric or quartz fabric. The thickness of the reinforcing material is not specially defined. In consideration that the laminates have good size stability, said woven fabrics and non-woven fabrics preferably have a thickness of 0.01-0.2mm, best after open fiber processing and surface processing with silane coupling agents. In order to provide better water resistance and heat resistance, the silane coupling agent is preferably anyone selected from the group consisting of epoxy silane coupling agent, amino silane coupling agent and vinyl silane coupling agent, or a mixture of at least two selected therefrom. The reinforcing material is impregnated with the aforesaid thermosetting resin composition, and oven-dried for 1-15 min at 100-250°C to obtain the prepreg.

The laminate for printed circuit boards of the present invention comprises a laminate prepared by bonding one or more prepregs together via heating and pressing, and metal foils bonded to one or both sides of the laminate. The laminate is obtained by curing in a hot pressing machine at a curing temperature of 150°C-250°C and a pressure of 10-60Kg/cm². The metal foils are copper foils, nickel foils, aluminium foils, SUS foils and the like, and the materials are not limited.

In order to better state the present invention and to better understand the technical solution of the present invention, the typical, but non-limitative examples of the present invention are stated as follows.

As for the laminate for printed circuit boards prepared above (8 sheets of prepregs, the reinforcing material having a model No.106, and having a thickness of 0.05mm), the glass transition temperature, dielectric constant, dielectric loss factor, water absorption, heat resistance, flame retardancy and the like are tested, and further and detailedly stated and described in the following examples.

Please refer to Examples 1-7 and Comparison Examples 1-11. Unless otherwise specified, the "part(s)" refers to "part(s) by weight", and the "%" refers to "wt. %".
(A) Halogen-free epoxy resin;
   (A-1) Dicyclopentadiene epoxy resin HP-7200H (Trade name from DIC, EEW:275g/eq);
   (A-2) Biphenyl novolac epoxy resin NC-3000H (Trade name from Japan Chemical, EEW:288g/eq);
(B) benzoxazine resin;
   (B-1) Bisphenol A benzoxazine HUN 8290N62 (Trade name from HUNTSMAN);
   (B-2) Dicyclopentadiene benzoxazine HUN 8260N70 (Trade name from HUNTSMAN);
(C) Curing agent;
   (C-1) phosphorus-containing bisphenol FRX OL3001 (Trade name from FRX Polymers, having a phosphorus content of 10% and a weight average molecular weight of 2400-3000);
   (C-2) phosphate PX-200 (Trade name from DAIHACHI CHEMICAL INDUSTRY CO.,LTD, having a phosphorus content of 9%) having the following structural formula 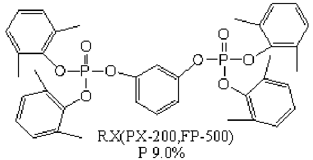
   (C-3) Polyphosphonates OL5000(Trade name from FRX Polymers, having a phosphorus content of 10.8%) having the following structural formula 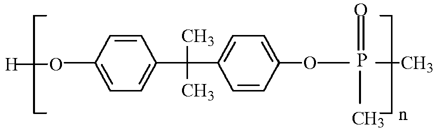
   (C-4) Bisphenol A bis-(diphenyl phosphate) FYROLFLEX BDP (Trade mark from Akzo Nobel, having a weight average molecular weight less than 1000) having the following structural formula 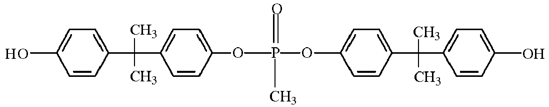
   (C-5) Polybenzyl phosphate Fyrol PMP (Trade name from ICL, Israel) having the following structural formula 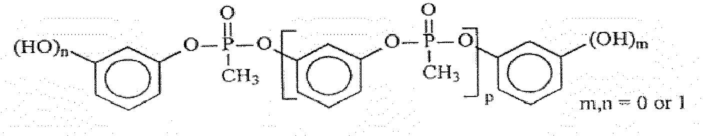
(D) Filler;
   (D1) Molten silicon dioxide (having an average particle size of 1-10µm and a purity higher than 99%);
   (D2) Aluminum hydroxide (having an average particle size of 1-10µm and a purity higher than 99%)
(E) Accelerator: 2-phenyl imidazole (SHIKOKU CHEMICALS)

Tables 1-3 show the formulations and physical properties thereof in Examples 1-7 and Comparison Examples 1-11.

**Table 1**

| | Example 1 | Example 2 | Example 3 | Example 4 | Example 5 | Example 6 | Example 7 |
|---|---|---|---|---|---|---|---|
| A-1 | 16 | 35 | 42 | --- | 35 | --- | 35 |
| A-2 | --- | --- | --- | 35 | --- | 35 | --- |
| B-1 | 4 | 4.8 | 1.5 | 4.8 | --- | --- | 4.8 |
| B-2 | --- | --- | --- | --- | 4.8 | 4.8 | --- |
| C-1 | 10 | 20.2 | 26.5 | 20.2 | 20.2 | 20.2 | --- |
| C-2 | --- | --- | --- | --- | --- | --- | --- |
| C-3 | --- | --- | --- | --- | --- | --- | --- |
| C-4 | --- | --- | --- | --- | --- | --- | --- |
| C-5 | --- | --- | --- | --- | --- | --- | 20.2 |
| D-1 | 70 | 40 | 30 | 40 | 40 | 40 | 40 |
| D-2 | --- | --- | --- | --- | --- | --- | --- |
| E | q.s. | q.s. | q.s. | q.s. | q.s. | q.s. | q.s. |
| Glass transition temperature (DSC)°C | 185 | 183 | 179 | 178 | 181 | 178 | 170 |
| Dielectric constant (1GHz) | 3.60 | 3.58 | 3.53 | 3.56 | 3.56 | 3.53 | 3.71 |
| Dielectric loss (1GHz) | 0.0061 | 0.0063 | 0.0067 | 0.0065 | 0.0066 | 0.0065 | 0.0078 |
| Water absorption (%) | 0.07 | 0.07 | 0.08 | 0.08 | 0.08 | 0.08 | 0.09 |
| Dip soldering resistance 288°C, s | >120 | >120 | >120 | >120 | >120 | >120 | 100 |
| Incombustibility | V-0 | V-0 | V-0 | V-0 | V-0 | V-0 | V-0 |

**Table 2**

| | Comparison Example 1 | Comparison Example 2 | Comparison Example 3 | Comparison Example 4 | Comparison Example 5 | Comparison Example 6 |
|---|---|---|---|---|---|---|
| A-1 | 35 | 35 | 35 | --- | 35 | --- |
| A-2 | --- | --- | --- | 35 | --- | 35 |
| B-1 | 5 | 4.8 | 4.8 | --- | 4.8 | --- |
| B-2 | --- | --- | --- | 4.8 | --- | 4.8 |
| C-1 | 20 | 20.2 | --- | --- | --- | --- |
| C-2 | --- | --- | 20.2 | 20.2 | --- | --- |
| C-3 | --- | --- | --- | --- | 20.2 | 20.2 |
| C-4 | --- | --- | --- | --- | --- | --- |
| C-5 | --- | --- | --- | --- | --- | --- |
| D-1 | 40 | --- | 40 | 40 | 40 | 40 |
| D-2 | --- | 40 | --- | --- | --- | --- |
| E | q.s. | q.s. | q.s. | q.s. | q.s. | q.s. |
| Glass transition temperature (DSC)°C | 176 | 182 | 157 | 159 | 174 | 176 |
| Dielectric constant (1GHz) | 3.75 | 3.80 | 3.88 | 3.85 | 3.94 | 3.91 |
| Dielectric loss (1GHz) | 0.0093 | 0.0112 | 0.0091 | 0.0097 | 0.0097 | 0.0094 |
| Water absorption (%) | 0.07 | 0.09 | 0.08 | 0.08 | 0.11 | 0.12 |
| Dip soldering resistance 288°C, s | 110 | 85 | >120 | >120 | 102 | 95 |
| Incombustibility | V-0 | V-0 | V-0 | V-0 | V-0 | V-0 |

**Table 3**

| | Comparison Example 7 | Comparison Example 8 | Comparison Example 9 | Comparison Example 10 | Comparison Example 11 |
|---|---|---|---|---|---|
| A-1 | 35 | 35 | 35 | 35 | 35 |
| A-2 | --- | --- | --- | --- | --- |
| B-1 | 20 | 25 | --- | 4.8 | 20 |
| B-2 | --- | --- | --- | --- | --- |
| C-1 | 5 | --- | 25 | --- | --- |
| C-2 | --- | --- | --- | --- | --- |
| C-3 | --- | --- | --- | --- | --- |
| C-4 | --- | --- | --- | 20.2 | --- |
| C-5 | --- | --- | --- | --- | 5 |
| D-1 | 40 | 40 | 40 | 40 | 40 |
| D-2 | --- | --- | --- | --- | --- |
| E | q.s. | q.s. | q.s. | q.s. | q.s. |
| Glass transition temperature (DSC)°C | 185 | 183 | 180 | 152 | 179 |
| Dielectric constant (1GHz) | 3.95 | 4.02 | 3.59 | 3.61 | 3.98 |
| Dielectric loss (1GHz) | 0.0105 | 0.0109 | 0.0065 | 0.0068 | 0.0103 |
| Water absorption (%) | 0.08 | 0.07 | 0.12 | 0.08 | 0.07 |
| Dip soldering resistance 288°C, s | 90 | 75 | >120 | 45 | 84 |
| Incombustibility | V-1 | V-1 | V-0 | V-0 | V-1 |

The aforesaid properties are tested by the following methods.
(a) Glass transition temperature (Tg): tested according to the DSC method as stipulated under IPC-TM-650 2.4.25, in accordance with the differential scanning calorimetry method (DSC).
(b) Dielectric constant and dielectric loss factor: tested by the resonance method using strip lines as stipulated under IPC-TM-650 2.5.5.5, under a frequency of 1 GHz.
(c) Water absorption: tested by the method as stipulated under IPC-TM-650 2.6.2.1.
(d) Dip soldering resistance: observing the stratification and bubbling time according to IPC-TM-650 2.4.13.1.
(e) Incombustibility: tested by the vertical combustion method as stipulated under UL 94.

According to the physical property data in Tables 1-3, it can be seen that Comparison Example 1 cured dicyclopentadiene epoxy resin with phosphorus-containing bisphenol and 5 parts by weight of bisphenol A type benzoxazine, and the prepared copper clad plate has worse dielectric performances and a general heat resistance. Comparison Example 2 cured dicyclopentadiene epoxy resin with phosphorus-containing bisphenol and bisphenol A type benzoxazine, and used aluminium hydroxide as the filler, and the prepared copper clad plate has worse dielectric performances and heat resistance. Comparison Example 3 cured dicyclopentadiene epoxy resin with phosphates containing no hydroxyl groups and bisphenol A type benzoxazine, comparison Example 4 cured biphenyl type epoxy resin with phosphates containing no hydroxyl groups and dicyclopentadiene benzoxazine, and the prepared copper clad plate has a lower Tg, a higher dielectric constant and dielectric loss, and thus cannot meet the requirements of laminates in the field of thermosetting high-speed field on dielectric performances. Comparison Example 5 cured dicyclopentadiene type epoxy resin with polyphosphonates containing single hydroxyl groups and having a phosphorus content higher than 10% and bisphenol A type benzoxazine. Comparison Example 6 cured biphenyl type epoxy resin with polyphosphonates containing single hydroxyl groups and having a phosphorus content higher than 10% and dicyclopentadiene benzoxazine, and the prepared copper clad plate has worse dielectric performances and heat resistance, and a higher water absorption. Comparison Example 7 cured dicyclopentadiene epoxy resin with 20 parts by weight of bisphenol A type benzoxazine and phosphorus-containing bisphenol, and the prepared copper clad plate does not have ideal dielectric performances, heat resistance or flame retardancy. Comparison Example 8 cured dicyclopentadiene epoxy resin with bisphenol A type benzoxazine alone, and the prepared copper clad plate has worse dielectric performances and insufficient heat resistance and flame retardancy. Comparison Example 9 cured dicyclopentadiene epoxy resin with phosphorus-containing bisphenol alone, and the prepared copper clad plate has a high Tg, excellent dielectric performances, but a too high water absorption which readily results in absorbing moisture and delamination during the processing. Comparison Example 10 cured dicyclopentadiene epoxy resin with phosphorus-containing bisphenol having a weight average molecular weight less than 1000 and a small amount of bisphenol A type benzoxazine, and the prepared copper clad plate has a too low Tg and a worse heat resistance. Comparison Example 11 cured dicyclopentadiene epoxy resin with a small amount of polybenzyl phosphate and bisphenol A type benzoxazine (in a ratio of 2.5/10), and the prepared copper clad plate has general dielectric performances and worse heat resistance and flame retardancy.

Examples 1-6 co-cured a halogen-free epoxy resin having a specific structure with phosphorus-containing bisphenol and a suitable amount of benzoxazine, together with a filler in a higher ratio. The resultant laminates have high glass transition temperature, excellent dielectric performances, low water absorption, high heat resistance and achieve halogen-free retardancy, and the flame retardancy achieves the UL94 V-0 grade. Example 7 used polybenzyl phosphate and a small amount of bisphenol A type benzoxazine to cure dicyclopentadiene epoxy resin, and the prepared copper clad plate has a higher Tg and better dielectric performances. Since polybenzyl phosphate contains no bisphenol A structure, phosphorus reaction units have a dense distribution, rendering that the reaction is too fast and easy to form steric hindrance, and reactive groups are easy to remain after curing. As compared to Example 2, the cured product has a lower Tg and worse dielectric performances and heat resistance.

As stated above, the laminates for printed circuit boards of the present invention have higher glass transition temperature, better dielectric performances, moisture resistance, heat resistance, and are suitable for the thermosetting field as compared to general laminates. In addition, the halogen content can achieve the V-0 standard in the flammability test UL94 within the scope of JPCA halogen-free standard requirements and have environmental protection effect.

The aforesaid examples are only preferred embodiments of the present invention. Those ordinarily skilled in the art can make other various corresponding changes and
deformations according to the technical solutions and concepts of the present invention, which all belong to the scope claimed in the claims of the present invention.

## Claims

1. A halogen-free thermosetting resin composition comprising, based on 100 parts by weight of organic solids,
(A) from 16 to 42 parts by weight of a halogen-free epoxy resin,
(B) from 1.5 to 4.8 parts by weight of a compound containing dihydrobenzoxazine ring;
(C) from 10 to 28 parts by weight of a phosphorus-containing bisphenol curing agent, wherein the phosphorus-containing bisphenol curing agent has a weight average molecular weight of 1000-6500, and
(D) from 30 to 70 parts by weight of silicon dioxide.

2. The halogen-free thermosetting resin composition claimed in claim 1, **characterized in that** the halogen-free epoxy resin is anyone selected from the group consisting of bisphenol A epoxy resin, bisphenol F epoxy resin, o-cresol novolac epoxy resin, bisphenol A novolac epoxy resin, triphenol novolac epoxy resin, dicyclopentadiene novolac epoxy resin, biphenyl novolac epoxy resin, alkylbenzene novolac epoxy resin and naphthol novolac epoxy resin, or a mixture of at least two selected therefrom.

3. The halogen-free thermosetting resin composition claimed in claim 1, **characterized in that** the halogen-free epoxy resin is selected from the epoxy resins having the following structure: 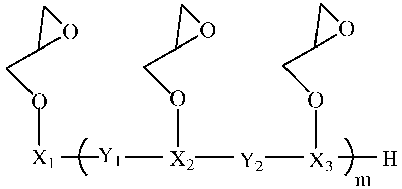 wherein X₁, X₂ and X₃ are each independently selected from the group consisting of 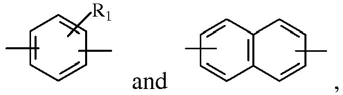 wherein R₁ is anyone selected from the group consisting of hydrogen atom, substituted or unsubstituted C1-C5 linear chain alkyl group, and substituted or unsubstituted C1-C5 branched chain alkyl group;
Y₁ and Y₂ are each independently anyone selected from the group consisting of single bond, -CH₂-, 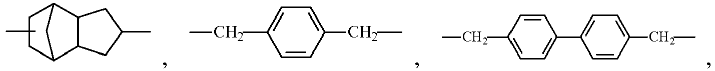 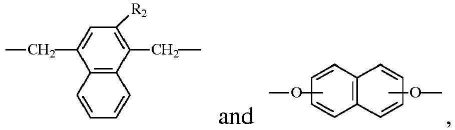 wherein R₂ is anyone selected from the group consisting of hydrogen atom, substituted or unsubstituted C1-C5 linear chain alkyl group, and substituted or unsubstituted C1-C5 branched chain alkyl group; and m is an integer selected from 1-10.

4. The halogen-free thermosetting resin composition claimed in any of claims 1-3, **characterized in that** the compound having dihydrobenzoxazine ring is anyone selected from the group consisting of bisphenol A benzoxazine shown in formula (I), bisphenol A benzoxazine shown in formula (II), bisphenol F benzoxazine, MDA benzoxazine, phenolphthalein benzoxazine and dicyclopentadiene benzoxazine, or a mixture of at least two selected therefrom; 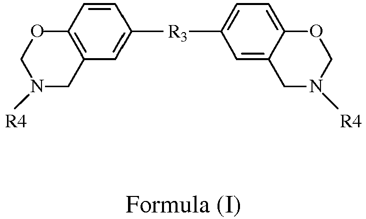 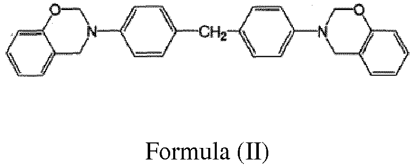 wherein R₃ is anyone selected from the group consisting of 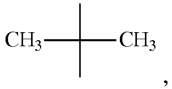 -CH₂-, 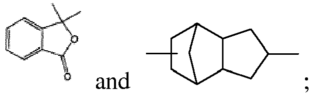 R₄ is

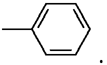

5. The halogen-free thermosetting resin composition claimed in any of claims 1-4, **characterized in that** phosphorus in the phosphorus-containing bisphenol curing agent is in an amount of 8 wt.%-10 wt.% of the phosphorus-containing bisphenol curing agent.

6. The halogen-free thermosetting resin composition claimed in any of claims 1-5, **characterized in that** the phosphorus-containing bisphenol curing agent has the following structure: 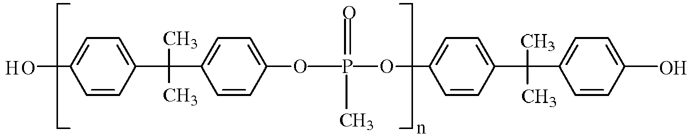 wherein n is an integer from 2 to 20, preferably an integer from 3 to 10;
preferably, the phosphorus-containing bisphenol curing agent has a weight average molecular weight of 1000-4500, preferably 1000-3000.

7. The halogen-free thermosetting resin composition claimed in any of claims 1-6, **characterized in that** the silicon dioxide is molten silicon dioxide;
preferably, the silicon dioxide has a median particle diameter of 0.01-50µm, preferably 0.01-20µm, further preferably 0.1-10µm.

8. The halogen-free thermosetting resin composition claimed in any of claims 1-7, **characterized in** further comprising (E) a curing accelerator;
preferably, the curing accelerator is anyone selected from the group consisting of imidazole compounds, derivatives of imidazole compounds, piperidine compounds, Lewis acid and triphenylphosphine, or a mixture of at least two selected therefrom, preferably from the group consisting of 2-methylimidazole, 2-ethyl-4-methylimidazole, 2-phenylimidazole and triphenylphosphine, or a mixture of at least two selected therefrom;
preferably, the imidazole compound is anyone selected from the group consisting of 2-methylimidazole, 2-ethyl-4-methylimidazole, 2-phenylimidazole and 2-undecylimidazole, or a mixture of at least two selected therefrom;
preferably, the piperidine compound is anyone selected from the group consisting of 2,3-diaminopiperidine, 2,5-diaminopiperidine, 2,6-diaminopiperidine, 2-amino-3-methylpiperidine, 2-amino-4-methylpiperidine, 2-amino-3-nitropiperidine, 2-amino-5-nitropiperidine and 2-amino-4,4-dimethylpiperidine, or a mixture of at least two selected therefrom;
preferably, the component (E) curing accelerator is added in an amount of from 0.01 to 1 part by weight, preferably from 0.05 to 0.8 parts by weight, further preferably from 0.05 to 0.6 parts by weight, based on 100 parts by weight of the sum of the addition amounts of the components (A), (B), (C) and (D).

9. A prepreg comprising a reinforcing material and the halogen-free thermosetting resin composition in any of claims 1-8 attached thereon after impregnation and drying.

10. A laminate comprising at least one prepreg claimed in claim 9.

11. A halogen-free high-frequency circuit substrate comprising at least one prepreg claimed in claim 9 and metal foils coated onto one or both sides of overlapped prepregs.
